Europäisches Patentamt

(19) European Patent Office

Office européen des brevets

(11) Publication number: **0 338 657**
**A1**

# EUROPEAN PATENT APPLICATION

(21) Application number: 89300843.3

(22) Date of filing: 27.01.89

(51) Int. Cl.⁴: **H01L 31/02**

The title of the invention has been amended (Guidelines for Examination in the EPO, A-III, 7.3).

(30) Priority: 30.01.88 GB 8802079

(43) Date of publication of application:
25.10.89 Bulletin 89/43

(84) Designated Contracting States:
DE ES FR GB IT

(71) Applicant: **The British Petroleum Company p.l.c.**
**Britannic House Moor Lane**
**London EC2Y 9BU(GB)**

(72) Inventor: **Bruton, Timothy Michael**
**BP Solar International Unit 12 Windmill Road**
**Sunbury-on-Thames Middlesex(GB)**
Inventor: **Cunningham, Daniel William**
**6 Chase Hill English Village**
**Newark Delaware(US)**

(74) Representative: **Ryan, Edward Terrence et al**
**BP INTERNATIONAL LIMITED, Patents**
**Division Chertsey Road**
**Sunbury-on-Thames Middlesex, TW16 7LN(GB)**

(54) Method for producing a silver electrode on a photovoltaic silicon cell.

(57) Production of photovoltaic cells from crystalline silicon with a silicon nitride anti-reflection coating, thereby making ohmic contact with the silicon by applying to the anti-reflection coating a layer of material for producing a silver electrode and then heating the cells under specified conditions.

# PRODUCING SEMICONDUCTOR LAYERS

The present invention relates to the manufacture of photovoltaic cells based on silicon.

It has been disclosed by K. Emmery et al 16th IEEE Photovoltaics Specialist Conference, 1982, pages 947-951 that photovoltaic cells may be produced from crystalline silicon by a method which involves applying an anti-reflective coating to the top surface of a doped crystalline silicon layer, and then applying a top contact or electrode by depositing a silver paste on the anti-reflection coating, using a screen printing process, and then subjecting the paste to elevated temperatures to cause an ohmic contact to be established through the anti-reflection coating to the underlying silicon. The anti-reflection coating disclosed is titanium dioxide.

It is disclosed in US 4 640 001 that silicon nitride may be used as an anti-reflection coating. Silicon nitride has advantages over other known anti-reflection coatings based on oxides. US 4 640 001 explains that the technique of baking the electrode or top contact deposited on the anti-reflection coating so as to "fire through" the contact through the anti-reflection coating cannot be used with most materials other than titanium dioxide.

The method described in US 4 640 001 for forming contacts between the top electrode and the underlying polycrystalline silicon to give photovoltaic cells comprises partial removal of silicon nitride in the region where the electrode is to be deposited. This is done by a complex process involving HF.

It would be desirable to find a simpler and cheaper method of making ohmic contacts between the top contact and the silicon in photovoltaic cells having an anti-reflection coating based on silicon nitride.

We have now found that it is possible to avoid complex and costly etching treatments by suitable choice of the conditions used to apply the top contact.

According to the present invention the process for making a photovoltaic cell by depositing an anti-reflection coating of silicon nitride on a crystalline silicon layer, and then depositing a silver electrode so as to make ohmic contact over the silicon layer through the anti-reflection coating is characterised in that

(a) a material forming a silver electrode on heating is deposited on the silicon nitride layer, and

(b) the material forming the silver electrode is subjected to a temperature of $730°C$ to $760°C$ for a time in the range 36 to 76 seconds.

The crystalline silicon may be single crystal silicon or polycrystalline silicon.

The silicon nitride anti-reflection coating is a hydrogenated amorphous alloy of silicon and nitrogen. It may be deposited on the silicon by plasma chemical vapour deposition as described in US 4 640 001.

The material producing the silver electrode or top contact may be one of the well known silver pastes. These are described in K. Firor et al 1982 IEEC p 824 and C.J. Sabo et al, Proc 1985 Inter. Symposium on Microelectronics and are commercially available for example from Ferro Corpn, T.F.S. Pastes and E.I. duPont de Nemours.

It is particularly preferred to apply the material forming the silver electrode by a screen printing process.

After the deposition of the material giving the silver electrode the combination of silicon, anti-reflection coating and electrode-forming material is subjected to elevated temperature for a controlled period of time.

The required conditions can be obtained by using a conventional thick film oven heated by infra-red radiation. The duration of the heating step may be controlled by passing material to be heated through the oven on a conveyor at appropriate belt speeds for example speeds in the range 30 inches $min^{-1}$ to 15 inches $min^{-1}$ (760 mm $min^{-1}$ to 380 mm $min^{-1}$).

The invention will now be illustrated by reference to the following Experiments in which experiments according to the invention are identified by numbers and comparative experiments not according to the invention are identified by letter.

## Example 1

In this comparative test 150 p-doped polycrystalline silicon wafers (Area, 100 cm²) were etched in an aqueous sodium hydroxide solution to remove saw damage. Using a spin-on source, a P-N junction was formed by phosphorus diffusion in an air atmosphere.

A silver back contact was screen printed on the p-doped side of the polycrystalline wafer. The silver paste used for the back contact contained a trace of aluminium. The back contact was fired into the silicon using a conventional fast fire IR belt furnace. After this, the semi-processed wafer was treated with a dilute aqueous hydrofluoric acid solution to prepare the front surface for silicon nitride deposition. This anti-reflection coating was formed by plasma enhanced chemical vapour deposition at a rate of 42 nm/minute (total thickness 80 nm).

The silver front contact was then screen printed directly on to the silicon nitride film and fired in an identical furnace to that described for the back contact. This consisted of the front contact being heated to a temperature of 740°C for 54 seconds. After firing was complete the cells were treated with 1% aqueous hydrogen fluoride solution and edge isolated using a 92% CF₄/8% oxygen plasma.

The complete cells from the process had an average efficiency of 12.1% with a maximum of 12.3% at 25°C/AM 1.5 insolation 100 mW/cm³.

Comparative Test A

In this test p-doped polycrystalline silicon (Area 100 cm²) wafers were processed in an identical manner to that described in Example 1 up to the firing of the silver front contact. Firing conditions for the front contact were as follows. A peak firing temperature of 700°C was used and the residence time of the cells at this temperature was 54 seconds. The process after front contact firing was identical to Example 1.

Cells produced from Comparative Test A had significantly lower efficiencies compared to those from Example 1. For instance, the average efficiency was 7.8% into a maximum efficiency of 8.2%.

## Claims

1. A process for making a photovoltaic cell by depositing an anti-reflection coating of silicon nitride on a crystalline silicon layer, and then depositing a silver electrode so as to make ohmic contact over the silicon layer through the anti-reflection coating is characterised in that

(a) a material forming a silver electrode on heating is deposited on the silicon nitride layer,

(b) the material forming the silver electrode is subjected to a temperature of 730°C to 760°C for a time in the range 36-76 seconds.

2. A process according to claim 1 in which the cryatalline silicon material is polycrystalline silicon.

3. A process according to either one of claims 1 or 2 wherein the material forming the silver electrode is applied by a screen printing process.

4. A process according to any one of the preceeding claims wherein the material forming the silver electrode is heated by infra-red radiation and the duration of the heating step is controlled by passing material to be heated through an infra-red oven on a conveyor.

5. A process according to claim 4 wherein the conveyor is operated with a belt speed in the range 760 mm minutes⁻¹ to 380 mm minute⁻¹.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-3 612 085 (SHARP K.K.) * Column 3, line 28 - column 5, line 32; column 6, lines 4-8; claims 1-5,7; figure 1 * | 1-3 | H 01 L 31/02 |
| Y | US-A-4 375 007 (S.M. MARCUS) * Whole document * | 1-3 | |
| Y | EP-A-0 201 745 (TELEFUNKEN ELECTRONIC GmbH) * Page 3, line 29 - page 6, line 17; figures 1,2 * | 1-3 | |
| D,A | US-A-4 640 001 (S. KOIWAI et al.) * Whole document * | 1-3 | |
| A | JAPANESE JOURNAL OF APPLIED PHYSICS, SUPPLEMENTS, vol. 19, supplement 19-2, 1980, pages 67-70, Tokyo, JP; T. NUNOI et al.: "High performance BSF silicon solar cell with fire through contacts printed on AR coating" * Whole document * | 1,3 | TECHNICAL FIELDS SEARCHED (Int. Cl.4) H 01 L |
| A | PATENT ABSTRACTS OF JAPAN, vol. 7, no. 178 (E-191)[1323], 6th August 1983; & JP-A-58 84 468 (MITSUBISHI DENKI K.K.) 20-05-1983 * Whole document * | 1,3 | |

The present search report has been drawn up for all claims

| Place of search | Date of completion of the search | Examiner |
|---|---|---|
| THE HAGUE | 26-04-1989 | VISENTIN A. |